(19) Europäisches Patentamt

European Patent Office

Office européen des brevets

(11) **EP 1 686 687 A1**

(12) **EUROPEAN PATENT APPLICATION**

(43) Date of publication:
**02.08.2006 Bulletin 2006/31**

(51) Int Cl.:
*H03G 3/30* (2006.01)     *H03F 1/30* (2006.01)

(21) Application number: **06001532.8**

(22) Date of filing: **25.01.2006**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **27.01.2005  KR 2005007678**

(71) Applicant: **LG Electronics Inc.**
**Yongdungpo-Gu**
**Seoul (KR)**

(72) Inventor: **Han, Dong Ho**
**Anyang-si,**
**Gyeonggi-do (KR)**

(74) Representative: **Katérle, Axel et al**
**Wuesthoff & Wuesthoff**
**Patent- und Rechtsanwälte**
**Schweigerstraße 2**
**81541 München (DE)**

(54) **Apparatus for controlling transmission power in mobile communication terminal and method thereof**

(57)     A temperature compensating method in a mobile communication terminal according to a per temperature output characteristic of a power amplifier is disclosed. The present invention includes a first step of detecting a per temperature output characteristic of the power amplifier, a second step of computing a per temperature maximum output deviation of the mobile communication terminal according to a result of the first step, a third step of finding a deviation of an automatic gain control signal according to the per temperature maximum output deviation of the mobile communication terminal, a fourth step of computing a temperature compensating value according to the deviation of the automatic gain control signal, and a fifth step of amplifying to transmit a radio signal by controlling the power amplifier according to the automatic gain control signal to which the temperature compensating value is applied.

Accordingly, the power level control of the transmission signal is facilitated by compensating the error of the transmission signal according to the temperature variation. And, in altering the configuration circuit or the material (PCB, etc.) of the mobile communication terminal, the present invention facilitates the re-computation of the temperature compensating value, thereby reducing the time, effort and cost for computing the temperature compensating value.

FIG. 1

## Description

This application claims the benefit of the Korean Patent Application No. 10-2005-0007678, filed on January 27, 2005, which is hereby incorporated by reference as if fully set forth herein.

## BACKGROUND OF THE INVENTION

### Field of the Invention

The present invention relates to a temperature compensating method in a mobile communication terminal according to an output characteristic of a power amplifier per temperature, and more particularly, to an apparatus for controlling a transmission power in a mobile communication terminal and method thereof. Although the present invention is suitable for a wide scope of applications, it is particularly suitable for computing a temperature compensating value of the mobile communication terminal by detecting the output characteristic of the power amplifier per temperature and for controlling the transmission power by varying a power level of a transmission signal according to a temperature variation.

### Discussion of the Related Art

Generally, a mobile communication terminal accesses a base station in a corresponding service area according to a wireless communication system and maintains a communication state in moving to enable an instant communication with a counter part regardless of time and location. The mobile communication terminal maintains its wireless access state to the base station due to its operational characteristics, which is to confirm a moving direction of the mobile communication terminal and a distance from the base station. To maintain uniform communication sensitivity, a power level of the mobile communication terminal should be maintained at a constant level.

A mobile communication terminal according to a related art controls a power level of a transmission signal according to a distance variation from a base station. Such a transmission power control of the mobile communication terminal shows non-linear characteristics according to a configuration circuit, temperature variation and usable frequency band of the mobile communication terminal.

In this case, the mobile communication terminal computes a compensating value according to a temperature variation so that a compensated transmission signal can be transmitted at a specific power level. And, the mobile communication terminal stores a value for a temperature compensation to use in transmission power control.

The mobile communication terminal performs RF transmission compensation, temperature compensation and the like to control the power level of the transmission signal.

The mobile communication terminal computes a transmission level of an RF signal in a manner that a communication module detects a level of an RF reception signal. Subsequently, by controlling a corresponding automatic gain control signal (AGC) for transmission, an output of the RF signal is delivered to an antenna. This is called a terminal output characteristic.

The RF signal, which is generated from the communication module, varies according to internal circuit characteristics until being transferred to the antenna that is an output end. To compensate this, the mobile communication terminal compensates an output automatic gain control signal (AGC). This is called an RF transmission compensation of a terminal and a corresponding value is called an RF transmission compensating value.

After a transmission level of the RF signal has been computed by detecting the level of the RF reception signal, the corresponding transmission automatic gain control signal (AGC) is controlled. In doing so, RF transmission is carried out in a manner of uniformly adding/subtracting a per temperature compensating value amounting to a difference of a maximum output according to the temperature variation to/from an RF transmission maximum output and an automatic gain control signal, which is called a temperature compensation.

In a temperature compensating method according to a related art, a per temperature compensating vale needs to be found one by one in a manner of applying compensating values according to a temperature variation (-30~60°C) to a prescribed sample terminal through several trials and errors. Hence, time and effort are excessively consumed in compensating value computation.

And, a mean value of the compensating values per temperature is collectively applied to the compensating value for the transmission signal of the mobile communication terminal. Moreover, since an output characteristic of a power amplifier having a large characteristic variation according to a temperature is not taken into consideration, an output error of a transmission signal becomes considerable.

Besides, since the related art compensating method needs to re-compute all values from the beginning to apply in case of altering a configurational circuit or PCB of the mobile communication terminal, time and effort are excessively consumed as well.

## SUMMARY OF THE INVENTION

Accordingly, the present invention is directed to an apparatus for controlling a transmission power in a mobile communication terminal and method thereof that substantially obviate one or more problems due to limitations and disadvantages of the related art.

An object of the present invention is to provide a temperature compensating method in a mobile communication terminal according to a per temperature output characteristic of a power amplifier, by which an error of a transmission signal is reduced by detecting the per temperature output characteristic of the power amplifier to control a power level of a transmission signal variable according to a temperature variation and by computing a temperature compensating value of the mobile communication terminal and by which a temperature compensating value computation is facilitated even if a configuration circuit of the mobile communication terminal is varied.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, an apparatus for controlling a transmission power in a mobile communication terminal according to the present invention includes a power amplifier amplifying a radio signal with a gain characteristic corresponding to a computed transmission level, an automatic gain control unit generating an automatic gain control signal for controlling a gain of the power amplifier, a temperature compensating unit computing a maximum output deviation of the mobile communication terminal according to a temperature variation of the power amplifier, the temperature compensating unit compensating the automatic gain control signal using a per temperature compensating value according to the computed deviations, and a control unit controlling the automatic gain control unit and the temperature compensating unit by sensing the temperature variation of the power amplifier and by detecting an output characteristic of the power amplifier according to the temperature variation.

Preferably, the apparatus further includes a memory storing a per temperature output characteristic of the power amplifier and per temperature maximum output deviation information of the mobile communication terminal.

In another aspect of the present invention, a method of controlling a transmission power in a mobile communication terminal is characterized in compensating an output automatic gain control signal by reflecting an output characteristic of a power amplifier according to a temperature variation and an error value of a per temperature maximum output.

Preferably, the method includes a first step of detecting a per temperature output characteristic ($Ft(1\sim8)$) of the power amplifier, a second step of computing a per temperature maximum output deviation ($Pdt(1\sim8)$) of the mobile communication terminal according to a result of the first step, a third step of finding a deviation ($Adt(1\sim8)$) of an automatic gain control signal according to the per temperature maximum output deviation of the mobile communication terminal, a fourth step of computing a temperature compensating value ($A(1\sim8)$) according to the deviation of the automatic gain control signal, and a fifth step of amplifying to transmit a radio signal by controlling the power amplifier according to the automatic gain control signal to which the temperature compensating value ($A(1\sim8)$) is applied.

It is to be understood that both the foregoing general description and the following detailed description of the present invention are exemplary and explanatory and are intended to provide further explanation of the invention as claimed.

## BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 is a block diagram of a mobile communication terminal according to the present invention;

FIG. 2 is a graph of an output characteristic of an amplifier of a mobile communication terminal according to the present invention;

FIG. 3 is a flowchart of a temperature compensating method in a mobile communication terminal according to the present invention; and

## DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

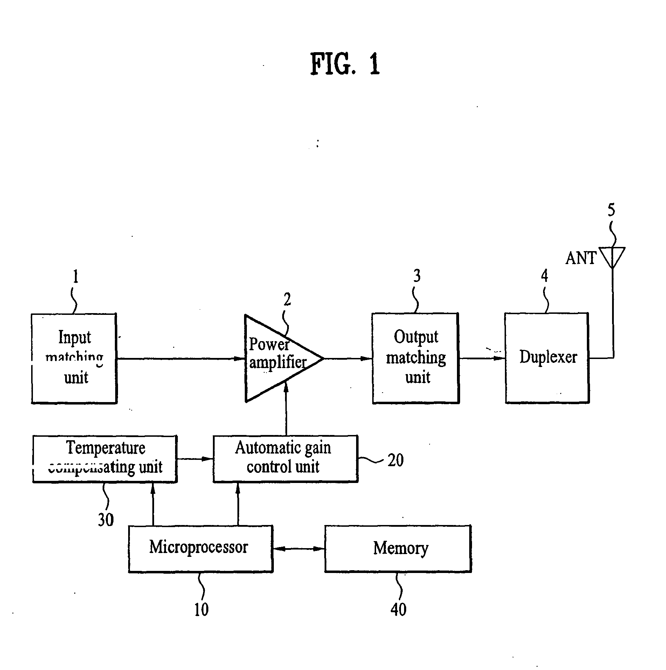

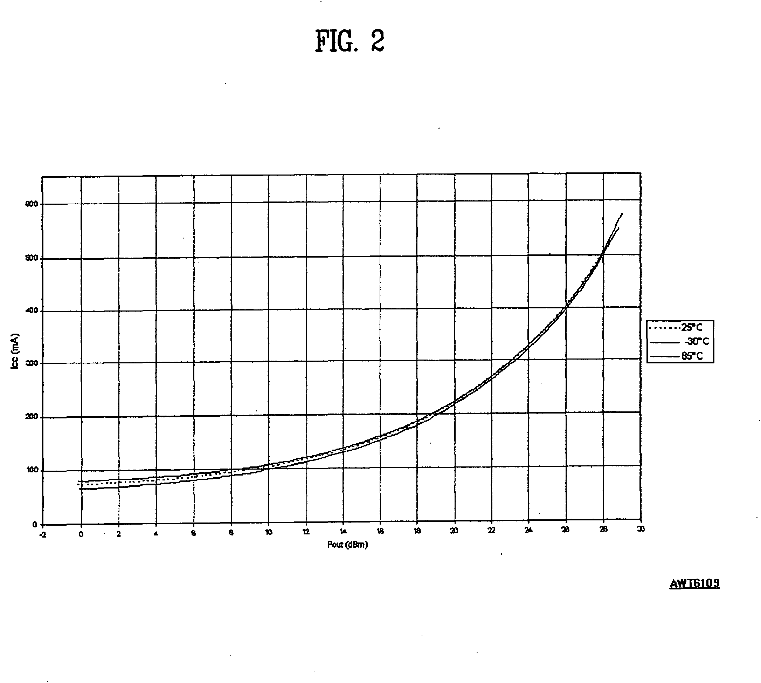

FIG. 1 is a block diagram of a mobile communication terminal according to the present invention and FIG. 2 is a graph of an output characteristic of an amplifier of a mobile communication terminal according to the present invention.

Referring to FIG. 1, a mobile communication terminal, which computes a temperature compensating value according to an output characteristic of a power amplifier, according to the present invention includes a power amplifier 2 amplifying a signal supplied via an input matching unit 1 with a gain characteristic, an automatic gain control unit 20 generating an automatic gain control signal for controlling a gain of the power amplifier 2, and a temperature compensating unit 30 compensating the automatic gain control signal by computing a per temperature compensating value according to a temperature variation of the power amplifier 2.

And, the mobile communication terminal further includes a microprocessor 10 generating a signal externally transmitted to be delivered to the input matching unit 1, the microprocessor 10 enabling a transmission signal amplified by the power amplifier 1 to be matched via an output matching unit 3 to be transferred to an antenna 5 via a duplexer 4, and the microprocessor 10 controlling the automatic gain control unit 20 and the temperature compensating unit 30.

The microprocessor 10 senses the temperature variation of the power amplifier 2 and detects the output characteristic of the power amplifier 2 according to the temperature variation.

In doing so, the microprocessor 10 divides a temperature range of -30~60°C into eight steps to detect the output characteristics according to the steps, respectively.

In this case, the output characteristic of the power amplifier 2, as shown in FIG. 2, is varied according to the temperature. A graph-a represents an output characteristic of the power amplifier 2 according to an input current at a low temperature of - 30°C, a graph-b represents an output characteristic of the power amplifier 2 according to an input current at a room temperature, and an output characteristic of the power amplifier 2 according to an input current at a high temperature of 85°C.

For instance, in case that the input current of the power amplifier 2 is 100mA, if the graph-b at 25°C and the graph-c at 85°C are compared to each other, there exists an output difference of about 1.5dBm at -30°C over the room temperature or an output difference of about 1dBm at 85°C over the room temperature.

In this case, the microprocessor 10 detects the output characteristics, as shown in FIG. 2, of the power amplifier 2 per the temperature step and then transfers the detected output characteristics to the temperature compensating unit 20 to compensate the variation of the output characteristic according to the temperature.

And, the microprocessor 10 detects the output characteristic of the power amplifier 2 at the room temperature, an output characteristic of the mobile communication terminal at the room temperature and the automatic gain control signal at the room temperature by the automatic gain control unit 20.

The automatic gain control unit 20 computes a level of a signal to be transmitted according to a location, usable frequency band, temperature and the like of the mobile communication terminal and then transfers the automatic gain control signal to the power amplifier 2 to amplify the signal according to the computed signal level.

The temperature compensating unit 30 computes the temperature compensating value according to each temperature level to correspond to the output characteristic value transferred from the microprocessor 10.

In this case, the temperature compensating unit 30 analyzes a characteristic value according to each temperature step by the microprocessor 10. And, the temperature compensating unit 30 computes a corresponding maximum output deviation of the mobile communication terminal per temperature and a corresponding deviation of the automatic gain control signal and then correspondingly computes the temperature compensating value per temperature.

The temperature compensating unit 30 transfers the computed temperature compensating value to the automatic gain control unit 20. The automatic gain control unit 20 applies the temperature compensating value to the automatic gain control signal to transfer the compensated automatic gain control signal to the power amplifier 2. Hence, a compensated transmission signal can be transmitted via the antenna 5.

The mobile communication terminal according to the present invention computes the temperature compensating value by considering a fact that the output characteristic varies according to the temperature variation of the power amplifier 2. Hence, it is able to reduce an error of the signal transmitted via the antenna. In case of re-computing the temperature compensating value like such a case that the configuration circuit of the mobile communication terminal is variable, the deviation computation of the temperature compensating unit 30 facilitates the computation of the temperature compensating value.

An operation of the above-configured present invention is explained as follows.

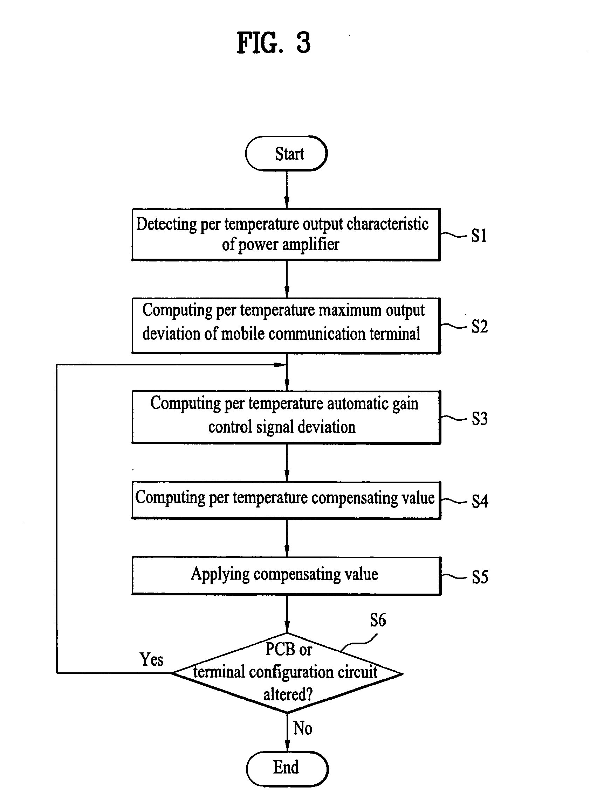

FIG. 3 is a flowchart of a temperature compensating method in a mobile communication terminal according to the present invention.

First of all, definitions of terms used in the following are explained as follows.

Atm: a maximum output automatic gain control value at a room temperature

Adt: an automatic gain control signal deviation value generated from a per temperature output difference

A(1~8): a per temperature output automatic gain control signal compensating value

Ft(1~8)(): a per temperature output characteristic

Ftm(): an output characteristic at a room temperature

Pdt(1~8): a per temperature output error value (dBm)

Pt(1~8): a per temperature output value (dBm)

Ptm: an output at a room temperature

A per temperature output characteristic according to each temperature step of the power amplifier is detected and an output characteristic of the power amplifier at the room temperature is detected. In doing so, by varying the temperature at the same output condition only, the characteristic Ft(1~8) of the power amplifier is detected.

In this case, by dividing a temperature range of -30~60 into eight steps, the output characteristic of the power amplifier per temperature according to each of the temperature steps is detected. The detected per temperature output characteristic of the power amplifier is separately stored in a memory 40 (see Figure 1) to be re-utilized in re-computing the temperature compensating value later.

The output characteristic of the power amplifier can be detected using a formula of 'P=F(A)' according to an output value. In this case, 'P' is a terminal output, 'F' is a power amplifier output characteristic, and 'A' is an automatic gain signal. Namely, the per temperature output characteristic of the power amplifier and the output characteristic of the power amplifier at the room temperature are detected using a measured output value of the mobile communication terminal and the formula used inversely according to the measured automatic gain control signal of the mobile communication terminal (S1).

According to the transmission signal transmitted via the antenna after being amplified by the power amplifier, a maximum output detection (P) of the mobile communication terminal and the corresponding deviation (Pdt) are computed. In doing so, according to the detected output characteristic (Ft) of the power amplifier, the per temperature maximum output deviation (Pdt(1~8)) of the mobile communication terminal can be computed. In this case, the value Atm that is not compensated is used in computing the per temperature maximum output deviation (Pdt(1~8)) of the mobile communication terminal.

This is expressed in formulas as follows.

$$Pt(1{\sim}8) = Ftm(Atm)$$

$$Ptm = Ftm(Atm)$$

$$Pdt(1{\sim}8) = Ptm - Pt(1{\sim}8)$$

The per temperature maximum output of the mobile communication terminal can be detected using the automatic gain control signal and the per temperature output characteristic of the power amplifier. A value of the automatic gain control signal, which controls a gain of the power amplifier, at the room temperature is detected.

Moreover, the maximum output value of the mobile communication terminal at the room temperature is detected using the output characteristic value of the power amplifier at the room temperature and the value of the automatic gain control signal at the room temperature.

By subtracting the per temperature maximum output of the mobile communication terminal from the maximum output of the mobile communication terminal at the room temperature, a per temperature maximum output deviation of the mobile communication terminal is computed. In doing so, the per temperature maximum output deviation of the mobile communication terminal is computed using the uncompensated value each (S2).

The per temperature deviation (Adt(1~8)) of the automatic fain control signal is computed using the computed maximum output deviation (Pdt(1~8) of the mobile communication terminal inversely.

This is expressed by formulas as follows.

$$Pdt(1{\sim}8) = Ft(1{\sim}8) \, (Adt(1{\sim}8)).$$

Hence, $Adt(1{\sim}8) = Ft(1{\sim}8)^{-1}(Pdt(1{\sim}8))$

Namely, the per temperature deviation of the automatic gain control signal is computed using an inverse function of the per temperature output characteristic of the power amplifier and the maximum output deviation of the mobile communication terminal (s3).

The temperature compensating value of the automatic gain control signal is computed by adding the deviation value of the per temperature automatic gain control signal and the automatic gain control signal at the room temperature together. And, the transmission signal is compensated by adding the computed temperature compensating value of the automatic gain control signal to the automatic gain control signal. Namely, it is computed like the formula of 'A(1~8) = Atm + Adt(1~8)' (S4).

It is able to control the signal to be transmitted in a manner of applying the above computed per temperature compensating value to the automatic gain control signal according to each temperature (S5).

Meanwhile, in case that the configuration circuit, a device for use, PCB or the like is varied in manufacturing the mobile communication terminal, the corresponding temperature compensating value is re-computed (S6).

In case of re-computing the temperature compensating value due to the variable circuit configuration and material and the like of the mobile communication terminal, instead of computing the temperature compensating value according to the mobile communication terminal, the deviation of the automatic gain control signal of the mobile communication terminal is re-computed using the previously-stored per temperature output characteristic of the power amplifier and the maximum output deviation of the mobile communication terminal.

Thus, by repeating a series of the procedures of computing the automatic gain control signal and the corresponding compensating value, it is able to compute a new temperature compensating value of the mobile communication terminal (S3 to S5).

Accordingly, the pre sent invention provides the following effects or advantages.

First of all, in the transmission power control method in the mobile communication terminal according to the per temperature output characteristic of the power amplifier, the power level control of the transmission signal is facilitated by compensating the error of the transmission signal according to the temperature variation. This is because the temperature compensating value of the automatic gain control signal is computed by considering the per temperature output characteristic of the power amplifier of which output value is considerably varied according to the temperature variation.

Secondly, in altering the configuration circuit or the material (PCB, etc.) of the mobile communication terminal, the present invention facilitates the re-computation of the temperature compensating value, thereby reducing the time, effort and cost for computing the temperature compensating value.

It will be apparent to those skilled in the art that various modifications and variations can be made in the present invention without departing from the spirit or scope of the inventions. Thus, it is intended that the present invention covers the modifications and variations of this invention provided they come within the scope of the appended claims and their equivalents.

**Claims**

1. An apparatus for controlling a transmission power in a mobile communication terminal, comprising:

   a power amplifier amplifying a radio signal with a gain characteristic corresponding to a computed transmission level;
   an automatic gain control unit generating an automatic gain control signal for controlling a gain of the power amplifier;
   a temperature compensating unit computing a maximum output deviation of the mobile communication terminal according to a temperature variation of the power amplifier, the temperature compensating unit compensating the automatic gain control signal using a per temperature compensating value according to the computed deviations; and
   a control unit controlling the automatic gain control unit and the temperature compensating unit by sensing the temperature variation of the power amplifier and by detecting an output characteristic of the power amplifier according to the temperature variation.

2. The apparatus of claim 1, further comprising a memory storing a per temperature output characteristic of the power amplifier and per temperature maximum output deviation information of the mobile communication terminal.

3. A method of controlling a transmission power in a mobile communication terminal, **characterized in** compensating an output automatic gain control signal by reflecting an output characteristic of a power amplifier according to a temperature variation and an error value of a per temperature maximum output.

4. The method of claim 3, wherein a temperature range of -30~60 is divided into eight temperature steps ad wherein a temperature compensating value is computed for each of the eight temperature steps.

5. The method of claim 4, comprising:

   a first step of detecting a per temperature output characteristic (Ft(1~8)) of the power amplifier;
   a second step of computing a per temperature maximum output deviation (Pdt(1~8)) of the mobile communication terminal according to a result of the first step;
   a third step of finding a deviation (Adt(1~8)) of an automatic gain control signal according to the per temperature maximum output deviation of the mobile communication terminal;
   a fourth step of computing a temperature compensating value (A(1~8)) according to the deviation of the automatic gain control signal; and
   a fifth step of amplifying to transmit a radio signal by controlling the power amplifier according to the automatic gain control signal to which the temperature compensating value (A(1~8)) is applied.

6. The method of claim 5, wherein if a configuration circuit and/or PCB of the mobile communication terminal is altered, it is fed back to the third step.

7. The method of claim 5, wherein in the first step, a relation between the automatic gain control signal and an output at each temperature is measured for computation.

8. The method of claim 5, the second step comprising the sub-steps of:

   a first sub-step of computing an output value (Ptm) at a room temperature;
   a second sub-step of detecting a per temperature output value (Pt(1~8) of the mobile communication terminal; and
   a third sub-step of computing a maximum output deviation (Pdt) of the mobile communication terminal according to a temperature variation by subtracting the per temperature output value (Pt (1~8)) of the mobile communication terminal from the output value (Ptm) at the room temperature.

9. The method of claim 8, wherein in the first sub-step, the output value (Ptm) at the room temperature reflects an output characteristic (Ftm) of the power amplifier in a state to which a maximum output automatic gain control signal value (Atm) at the room temperature.

10. The method of claim 5, wherein in the third step, the deviation (Adt(1~8)) of the automatic gain control signal is computed by reflecting a per temperature maximum output deviation (Pdt(1~8)) of the mobile communication terminal and a per temperature output characteristic (Ft(1~8)) of the power amplifier.

11. The method of claim 5, wherein in the fourth step, a per temperature automatic gain control signal compensating value (A(1~8)) is computed by adding the per temperature automatic gain control signal deviation (Adt(1~8)) and the automatic gain control signal value (Atm) at the room temperature together.

12. The method of claim 5, wherein in the fifth step, a transmission signal is compensated by applying the temperature compensating value (A(1~8)) per temperature to the automatic gain control signal and by allowing the power amplifier to amplify the signal by the compensated automatic gain control signal.

EP 1 686 687 A1

# FIG. 1

:

8

# FIG. 2

EP 1 686 687 A1

# FIG. 3

```
                    ┌─────────────┐
                    │    Start    │
                    └─────────────┘
                           │
                           ▼
        ┌─────────────────────────────────────┐
        │ Detecting per temperature output     │
        │ characteristic of power amplifier    │──── S1
        └─────────────────────────────────────┘
                           │
                           ▼
        ┌─────────────────────────────────────┐
        │ Computing per temperature maximum    │
        │ output deviation of mobile           │──── S2
        │ communication terminal               │
        └─────────────────────────────────────┘
                           │
                           ▼
        ┌─────────────────────────────────────┐
        │ Computing per temperature automatic  │
        │ gain control signal deviation        │──── S3
        └─────────────────────────────────────┘
                           │
                           ▼
        ┌─────────────────────────────────────┐
        │ Computing per temperature            │──── S4
        │ compensating value                   │
        └─────────────────────────────────────┘
                           │
                           ▼
        ┌─────────────────────────────────────┐
        │ Applying compensating value          │──── S5
        └─────────────────────────────────────┘
                           │
                           ▼       S6
                      ╱─────────────╲
          Yes        ╱   PCB or      ╲
        ◄───────────  terminal configuration
                     ╲  circuit altered?     ╱
                      ╲─────────────╱
                           │ No
                           ▼
                    ┌─────────────┐
                    │     End     │
                    └─────────────┘
```

European Patent
Office

**EUROPEAN SEARCH REPORT**

Application Number

EP 06 00 1532

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 269 251 B1 (KIM HAK-HWAN) 31 July 2001 (2001-07-31) * abstract * * column 1, line 56 - column 2, line 18 * * column 3, line 39 - column 7, line 7 * * figures 2a,2b,3-7 * | 1-12 | H03G3/30 H03F1/30 |
| A | US 2002/158688 A1 (TEROSKY JASON ET AL) 31 October 2002 (2002-10-31) * abstract * * paragraphs [0040] - [0046] * * figure 1 * | 1-12 | |
| A | US 5 832 373 A (NAKANISHI ET AL) 3 November 1998 (1998-11-03) * column 9, line 64 - column 10, line 60 * * figure 9 * | 1-12 | |

TECHNICAL FIELDS
SEARCHED      (IPC)

H03G
H03F

The present search report has been drawn up for all claims

| Place of search | Date of completion of the search | Examiner |
|---|---|---|
| Munich | 16 March 2006 | Helms, J |

## ANNEX TO THE EUROPEAN SEARCH REPORT
## ON EUROPEAN PATENT APPLICATION NO.

EP 06 00 1532

This annex lists the patent family members relating to the patent documents cited in the above-mentioned European search report.
The members are as contained in the European Patent Office EDP file on
The European Patent Office is in no way liable for these particulars which are merely given for the purpose of information.

16-03-2006

| Patent document cited in search report | | Publication date | Patent family member(s) | | Publication date |
|---|---|---|---|---|---|
| US 6269251 | B1 | 31-07-2001 | CN | 1268011 A | 27-09-2000 |
| | | | DE | 10013716 A1 | 15-03-2001 |
| | | | GB | 2348329 A | 27-09-2000 |
| | | | KR | 2000060876 A | 16-10-2000 |
| US 2002158688 | A1 | 31-10-2002 | WO | 02069485 A2 | 06-09-2002 |
| US 5832373 | A | 03-11-1998 | CN | 1154768 A | 16-07-1997 |
| | | | JP | 8274559 A | 18-10-1996 |
| | | | WO | 9631954 A1 | 10-10-1996 |

EPO FORM P0459

For more details about this annex : see Official Journal of the European Patent Office, No. 12/82